# EUROPEAN PATENT APPLICATION

(11) **EP 3 703 237 A1**
(43) Date of publication of application: **02.09.2020**
(21) Application number: 19160324.0
(22) Date of filing: 01.03.2019
(51) Int. Cl.: H02M 5/458, G01R 31/02, H02M 1/32, H02M 7/5387, H02M 1/00

(54) **A METHOD FOR ONLINE MONITORING OF A DC-BUS CAPACITOR**

(71) Applicant: Mitsubishi Electric R & D Centre Europe B.V., 1119 NS Schiphol Rijk (NL); Mitsubishi Electric Corporation, Tokyo 100-8310 (JP)
(72) Inventor: FOUBE, Laurent, 35708 RENNES Cedex 7 (FR)
(74) Representative: Cabinet Le Guen Maillet

(57) **Abstract**

The present invention concerns a method and a device for on-line monitoring a DC-bus capacitor comprised in a power converter that controls the power provided to a load through an output stage at each switching cycle using a pulse width modulation. The invention:
- measures the voltage on the DC-bus capacitor, filters using an analogue filter the measured voltage in order to obtain filtered DC-link voltage ripple comprising only high frequency components generated by the pulse width modulation,
- samples, the filtered DC-link voltage ripple at a sampling rate that is a multiple of the frequency of the pulse width modulation,
- reconstructs for each segment of the pulse width modulation, the current provided to the output stage,
- executes a digital filtering of the reconstructed current in order to obtain samples of filtered reconstructed current at the same frequency as the samples of the filtered DC-link voltage ripple,
- calculates a root mean square value of the filtered DC-link voltage ripple and a root mean square value of the filtered reconstructed current,
- determines the equivalent serie resistance of the DC-bus and compares it to a threshold in order to determine if the DC-bus capacitor reaches its end of life.

## Description

### TECHNICAL FIELD

The present invention relates generally to a method and system for on-line monitoring a DC-bus capacitor that is included in a power converter.

### RELATED ART

In the field of Power Electronics, DC-bus capacitors are known as vulnerable components especially because usually electrolytic capacitors are used for that function. Their failure leads to out-of-service condition for the entire power converter.

DC-bus capacitors are often the most limiting factor for long-life products. This is the reason why we observe an increased interest in Condition Monitoring technologies, thus permitting a timely replacement of these components, while disturbance on the service rendered by the equipment is minimised.

Solutions have been proposed to detect ageing of DC-bus capacitors. Usually the ageing detection is made by monitoring the variation of some parameters of the DC-bus capacitor. For example, a reduction of the DC-bus capacitance value may be used to detect the end of life of the DC-bus capacitor, an increase of the equivalent series resistance (ESR) may be used to detect the end of life of the DC-bus capacitor or an increase of the loss factor may be used to detect the end of life of the DC-bus capacitor. The estimation of the parameters may be made by using measurements of the capacitor's voltage and current.

Capacitor ageing detection methods that operate during the operation of the power converter and that do not use capacitor current sensors are usually not accurate enough and require special mode of operation to be applicable like for example regenerative operation. However, there are some cases where it is not convenient or possible to add a capacitor current sensor for reasons such as minimization of cost, or because it would add parasitic inductance to the DC-bus which is usually not desirable.

A first factor that influences the accuracy of ageing detection is the definition of ageing limits. The ageing limit is usually either a fixed value at a given temperature, or a set of values for different temperatures derived either by initial pre-characterization of the type of capacitor monitored or from datasheet information. Data sheet information is not accurate enough for the particular capacitor(s) monitored due to a relatively large manufacturer tolerance. In addition, the estimation of ageing has its own accuracy, which constitutes an additional limiting factor for an accurate ageing detection.

### SUMMARY OF THE INVENTION

The present invention aims at providing a non-intrusive DC-bus capacitor condition monitoring system that is included in a power converter which is low cost, resilient to disturbances, has repeatable performance and does not need a special mode of operation of the power converter.

The present invention also aims at providing an on-line monitoring of a DC-bus capacitor condition using an accurate ESR value estimation method that operates during normal operation of a power converter.

To that end, the present invention concerns a method for on-line monitoring a DC-bus capacitor comprised in a power converter, the power converter controlling the power provided to a load through an output stage at each switching cycle using a pulse width modulation, characterized in that the method comprises the steps of:
- measuring the voltage on the DC-bus capacitor, filtering, using an analogue filter, the measured voltage of the DC-bus capacitor in order to obtain filtered DC-bus voltage ripple with frequency contents within a frequency band comprising only high frequency components generated by the pulse width modulation,
- sampling, the filtered DC-bus voltage ripple at a sampling rate that is a multiple of the frequency of the pulse width modulation,
- obtaining switching information of the pulse width modulation,
- sampling, at least one time within the time period of the pulse width modulation, the output currents provided to the load,
- reconstructing, for each segment of the pulse width modulation, the current provided to the output stage,
- executing a digital filtering of the reconstructed current in order to obtain samples of filtered reconstructed current at same frequency as the samples of the filtered DC-bus voltage ripple,
- calculating a root mean square value of the filtered DC-bus voltage ripple using the samples of the filtered DC-bus voltage ripple,
- calculating a root mean square value of the filtered reconstructed current using the samples of the filtered reconstructed current,
- determining the equivalent serie resistance of the DC-bus capacitor from the calculated root mean square values,
- measuring or estimating the capacitor temperature,
- comparing the equivalent series resistance value to a threshold which depends on the capacitor temperature and determining if the DC-bus capacitor reaches its end of life according to the comparison result.

The present invention concerns also a device for on-line monitoring a DC-bus capacitor comprised in a power converter, the power converter controlling the power provided to a load through an output stage at each switching cycle using a pulse width modulation, characterized in that the device comprises:
- means for measuring the voltage on the DC-bus capacitor, filtering, using an analogue filter, the measured voltage of the DC-bus capacitor in order to obtain filtered DC-bus voltage ripple with frequency contents within a frequency band comprising only high frequency components generated by the pulse width modulation,
- means for sampling the filtered DC-bus voltage ripple at a sampling rate that is a multiple of the frequency of the pulse width modulation,
- means for obtaining switching information of the pulse width modulation,
- means for sampling, at least one time within the time period of the pulse width modulation, the output currents provided to the load,
- means for reconstructing, for each segment of the pulse width modulation, the current provided to the output stage,
- means for executing a digital filtering of the reconstructed current in order to obtain samples of filtered reconstructed current at the same frequency as the samples of the filtered DC-bus voltage ripple,
- means for calculating a root mean square value of the filtered DC-bus voltage ripple using the samples of the filtered DC-bus voltage ripple,
- means for calculating a root mean square value of the filtered reconstructed current using the samples of the of filtered reconstructed current,
- means for determining the equivalent serie resistance of the DC-bus capacitor from the calculated root mean square values,
- means for measuring or estimating the capacitor temperature,
- means for comparing the equivalent series resistance value to a threshold which depends on the capacitor temperature and determining if the DC-bus capacitor reaches its end of life according to the comparison result.

Thus, the present invention enables an on-line monitoring of a DC-bus capacitor condition using an accurate ESR value estimation method that operates anytime during normal operation of a power converter.

Thanks to the present invention, it is not necessary to inject any disturbance to allow estimation of the capacitance value or the ESR value of the DC-bus capacitor, since the naturally present voltage and current ripple are used by the present invention.

The current going through the DC-bus capacitor is accurately calculated.

According to a particular feature, the digital filtering of the reconstructed current is performed using an infinite impulse response filter.

Thus, the filtering of the reconstructed current allows to reduce its frequency contents to the band of interest and enables its downsampling to the same frequency as sampled filtered DC-bus voltage ripple. In particular high frequency contents above half the downsampling frequency are attenuated in order to avoid aliasing effects. The digital filtering is also required to reject the harmonic out of band of interest for the estimation of ESR. An infinite impulse response filter (IIR) enables a simple implementation of filtering.

According to a particular feature, the digital filtering of the reconstructed current is performed using time domain solutions of a linear time-invariant filter.

Thus, such filter allows a faster execution time compared to filtering using an IIR (infinite impulse response) filter.

According to a particular feature, the filtered reconstructed capacitor current is downsampled at a rate at least equal to four times the frequency of the pulse width modulation.

Thus, the information of major switching harmonic is preserved like for example the second harmonic of the switching frequency in the case of SVPWM modulation).

According to a particular feature, the filtered DC-bus voltage ripple is sampled at a rate at least equal to four times the frequency of the pulse width modulation.

Thus, the information of major switching harmonic is preserved like for example the second harmonic of the switching frequency in the case of SVPWM modulation. Harmonics above half the sampling frequency are not required for estimation of ESR and are expected to be of sufficiently low amplitude as they are attenuated by the filtering to avoid aliasing.

According to a particular feature, the RMS values are calculated from an accumulation performed within a predetermined time window.

Thus, the result of RMS calculation is only updated at the end of a considered time window. The intermediate calculation performed during the time window is a simple accumulation of each squared sample value.

According to a particular feature, the power converter is a three-phase inverter having a diode rectifier front end.

Thus, the current delivered by the front end contains only low frequency contents (DC and low frequency disturbance). This is a common configuration found in motor drive inverters. A DC reactor is sometimes used to enhance the filtering of DC bus voltage by reducing the amplitude of the low ripple voltage ripple.

According to a particular feature, the pulse width modulation is a space vector modulation.

The space vector modulation permits a better DC-link utilization as it delivers more voltage to the load for a same DC-link voltage value compared to other types of modulations. The main switching harmonic is at twice the modulation frequency and constitutes thus a major frequency of interest for the estimation of ESR.

### BRIEF DESCRIPTION OF THE DRAWINGS

The characteristics of the invention will emerge more clearly from a reading of the following description of example embodiments, the said description being produced with reference to the accompanying drawings, among which:
Fig. 1 represents an example of an architecture of a power converter that is, in the example of Fig. 1, a three-phase inverter that includes a DC-bus capacitor condition monitoring system according to the present invention;
Fig. 2 represents the architecture of a processing unit of the DC-bus capacitor condition monitoring system according to the present invention;
Fig. 3 represents an example of an algorithm for monitoring the condition of a DC-bus capacitor of a power converter according to the present invention;
Fig. 4 represents signals of the three-phase inverter that are used according to the present invention;
Fig. 5 is an example of the digital filtering of the reconstructed current Iinv using an infinite impulse response filter;
Fig. 6 is an example of the digital filtering of the reconstructed current Iinv using time-domain solution of state-space equations of a linear time-invariant filter.

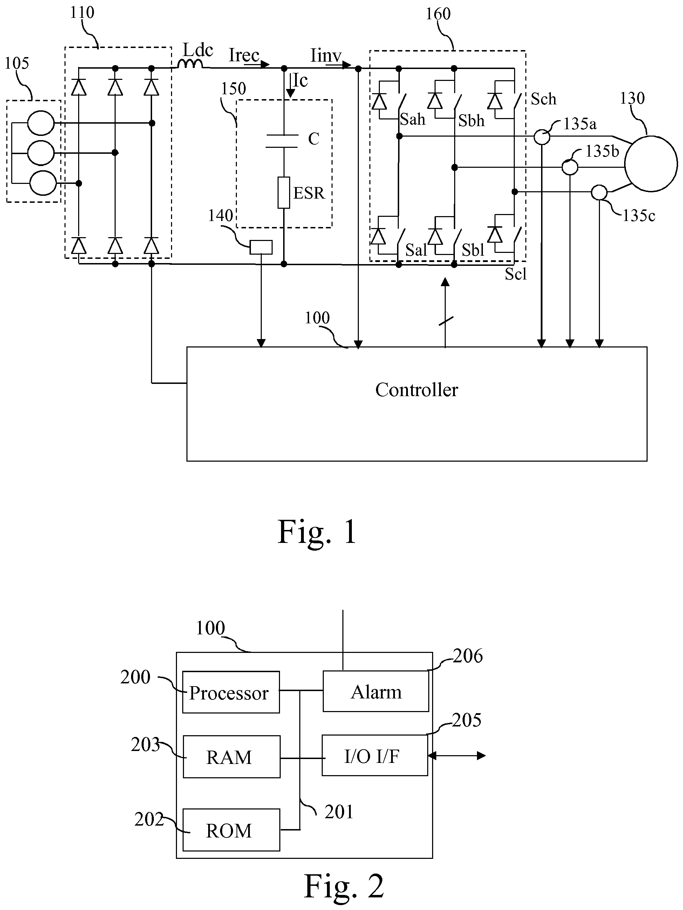

**Fig. 1** represents an example of an architecture of a power converter that is, in the example of Fig. 1, a three-phase inverter that includes a DC-bus capacitor condition monitoring system according to the present invention.

The power converter is mainly composed of an output stage that is, in the example of Fig. 1, a three-phase inverter 160, a DC-bus capacitor 150, a diode front end rectifier 110, followed possibly by a DC reactor Ldc and a processing unit 100.

The DC-bus capacitor 150 may be composed of plural capacitors, thus forming a capacitor bank.

The power converter may receive three-phase alternating electric (AC) power 105 and drives a load 130 that is, for example, a three-phase motor.

In a variant, the power converter receives electric power from a DC power supply, like for example, a photovoltaic system. In such variant, the power converter does not comprises a diode front end rectifier.

In another variant where the power converter is powered by alternating electric power, the front end of the power converter may include a PFC (power factor correction stage) following a diode front-end rectifier, for instance an interleaved boost converter switched at a frequency much higher than the output stage. In that case, the front end generates very high frequency harmonics out of band of analysis for ESR estimation.

In another variant, the front end of the power converter generates HF contents in the band of analysis for ESR estimation (for instance a boost stage switched at relatively low frequency) but allows either the calculation or the measurement of its output current Irec, then the current Irec can be subtracted from the reconstructed current Iinv to calculate the estimated capacitor current.

Each phase of the load 130 comprises one current sensor noted 135a, 135b and 135c. In a variant, only two phases of the load 130 comprise one current sensor, the current of the other phase of the load being determined from the values provided by the two current sensors.

The power converter may comprise a temperature sensor 140 that senses the temperature of the DC-bus capacitor 150. Alternatively, the temperature of capacitor may also be estimated considering the ambient temperature within the power converter and its operating point for instance, or from a known measured temperature in the volume of the converter.

According to the invention, the equivalent serie resistor value ESR of the DC-bus capacitor 150 is monitored.

The processing unit 100 controls the switches of the three-phase inverter 160, for example, using space vector modulation as pulse width modulation method and monitors the condition of the DC-bus capacitor. The three-phase inverter 160 converts a DC-bus voltage into three alternating output voltages, via a series of switches Sah, Sal, Sbh, Sbl, Sch and Scl, forming three output legs which are connected to the three-phase load 130.

The present invention intends to estimate the equivalent series resistance of the DC-bus capacitor 150 without creating any disturbances. The present invention uses high frequency ripple generated by the three-phase inverter 160 during normal operation considering that the electric power provided by the front end, for instance either a DC power supply or a diode front end rectifier, does not provide any high frequency ripple in the frequency band wherein measurements are performed according to the present invention. Then, the high frequency components of current Ic going through the DC-bus capacitor 150 are equal to the high frequency ripple current of Iinv generated by the three-phase inverter 160.

The present invention doesn't need any current sensor in series with the DC-bus capacitor 150 as the high frequency ripple current Ic going through the DC-bus capacitor 150 is estimated from an accurate reconstruction and filtering of the current Iinv.

The present invention considers the high frequency capacitor voltage and current in a frequency band of interest in order to determine the equivalent series resistance of the DC-bus capacitor 150.

The frequency band of interest for electrolytic capacitors typically expands from a few kHz up to maximum 100 kHz. In this frequency range, the influence of the capacitance value becomes negligible compared to the equivalent series resistance of the DC-bus capacitor 150. Also, the influence of the very low equivalent series inductance (ESL) can be neglected. The frequency band must also contain one or several significant harmonics of the switching frequency of the three-phase inverter 160.

Furthermore, if the resonant frequency (fᵣₑₛ) of DC-bus capacitor 150 is close to significant harmonics, the estimation of equivalent serie resistance is more accurate.

Then, the present invention does not need to know the current delivered by the rectifier (that can be either continuous or discontinuous depending on the value of DC reactor Ldc, operating point, etc.). The proposed on-line monitoring method can thus be applied to a power converter with a front end rectifier, with or without DC reactor, and does not require any particular mode of operation.

According to the invention:
- the voltage on the DC-bus capacitor 150 is measured, filtered using an analogue filter in order to obtain filtered DC-bus voltage ripple with frequency contents within a frequency band comprising only high frequency components generated by the pulse width modulation,
- the filtered DC-bus voltage ripple is sampled at a sampling rate that is a multiple of the frequency of the pulse width modulation,
- switching information of the pulse width modulation are obtained,
- the output currents provided to the load are sampled, at least one time within the time period of the pulse width modulation,
- the current provided to the output stage is reconstructed for each segment of the pulse width modulation,
- a digital filtering of the reconstructed current is performed in order to obtain samples of filtered reconstructed current at the same frequency as the samples of the filtered DC-bus voltage ripple,
- a root mean square value of the filtered DC-bus voltage ripple is calculated using the samples of the filtered DC-bus voltage ripple,
- a root mean square value of the filtered reconstructed current is calculated using the samples of the filtered reconstructed current,
- the equivalent serie resistance of the DC-bus capacitor is calculated from the calculated root mean square values,
- the equivalent series resistance value is compared to a threshold and it is determined if the DC-bus capacitor reaches its end of life according to the comparison result.

**Fig. 2** represents the architecture of a processing unit of the DC-bus capacitor condition monitoring system according to the present invention.

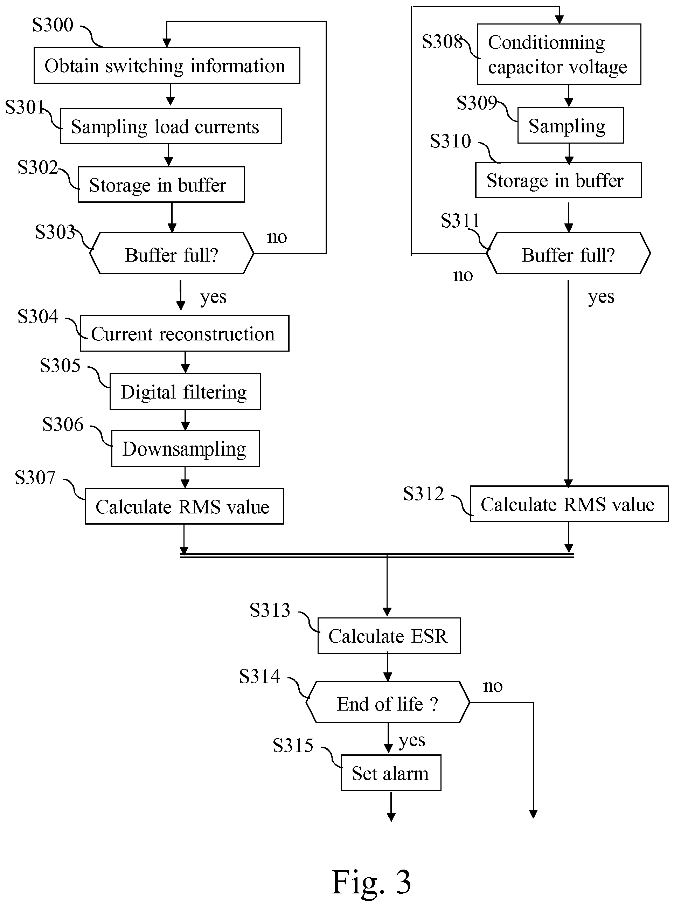

The processing unit 100 has, for example, an architecture based on components connected together by a bus 201 and a processor 200 controlled by a program as disclosed in Fig. 3.

The bus 201 links the processor 200 to a read only memory ROM 202, a random access memory RAM 203, an input output I/O IF interface 205 and an alarm interface 206. The memory 203 contains registers intended to receive variables and the instructions of the program related to the algorithm as disclosed in Fig. 3.

The processor 200 receives through the input output I/O IF 205 sensed temperature 140, current values sensed by the sensors 135a, 135b, 135c, the DC-bus capacitor voltage and transfers command signals to the three-phase inverter 160. The input output I/O IF includes an analogue to digital converter. Some analogue signal conditioning is also of course included like a scaling of high DC-bus voltage, low pass filtering like for example anti-aliasing filters in order to acquire the different signals like for example the DC-bus voltage, output phase currents.

The processor 200, upon detection of the end of life of the DC-bus capacitor 150, commands the alarm module 206 which is for example a LED or an alarm signal that notifies a maintenance request.

The read-only memory, or possibly a Flash memory 202, contains instructions of the programs related to the algorithm as disclosed in Fig. 3, when the processing unit 100 is powered on, are loaded to the random access memory 203. Alternatively, the program may also be executed directly from the ROM memory 202.

The control performed by the processing unit 100 may be implemented in software by execution of a set of instructions or program by a programmable computing machine, such as a PC (*Personal Computer*), a DSP (*Digital Signal Processor*) or a microcontroller; or else implemented in hardware by a machine or a dedicated component, such as an FPGA (*Field-Programmable Gate Array*) or an ASIC (*Application-Specific Integrated Circuit*).

In other words, the processing unit 100 includes circuitry, or a device including circuitry, causing the processing unit 100 to perform the program related to the algorithm as disclosed in Fig. 3.

**Fig. 3** represents an example of an algorithm for monitoring the condition of a DC-bus capacitor of a power converter according to the present invention.

The present algorithm is disclosed in an example wherein it is executed by the processor 200 of the processing unit 100 when the power converter is a three phase inverter.

At step S300, the processor 200 obtains the switching information of the three-phase inverter 160.

For example, the three phase inverter 160 is controlled using a space vector modulation used as a pulse width modulation method of the three-phase inverter 160.

Space vector modulation (SVM) is an algorithm for the control of pulse width modulation (PWM). This method is commonly used for motor drive applications to control the variable speed of a three-phase AC powered motor. The basic idea of the method is the synthesis of a rotating reference vector. During its rotation, the reference vector successively traverses the six sectors. The three-phase power inverter generates a complete low frequency electric period of each output phase voltage for each full rotation of the reference vector. A new reference vector is calculated every switching interval, typically at several kHz. The step S300 is thus performed once per switching interval.

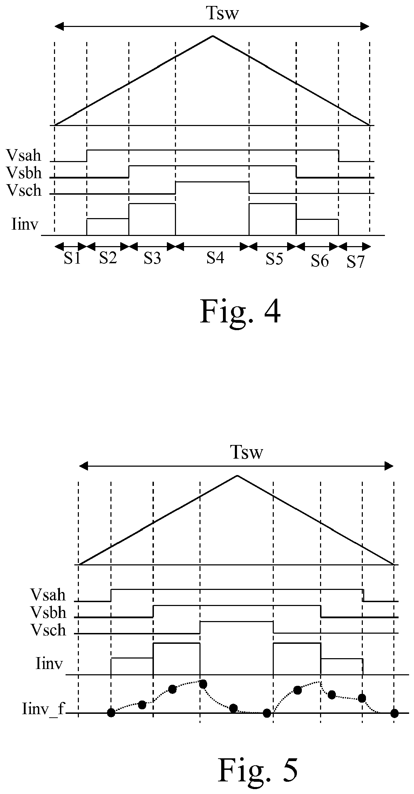

Each synthesis of the reference vector leads thus to the generation of a particular PWM pattern for the three-legs of inverter such as described on Fig. 4. Duration of activation of the different gate signals directly results from the synthesis process of the voltage reference vector which in turn depends on the control of the three-phase inverter.

**Fig. 4** represents signals of the three-phase inverter that are used according to the present invention.

Fig. 4 represents the variations of the three phase inverter current Iinv in a time period Tsw of the space vector modulation.

The signals Vsah, Vsbh and Vsch are the gate signals provided to the switches Sah, Sbh and Sch. The transitions of signals Vsah, Vsbh and Vsch define different regions or segments within the switching interval Tsw.

The three-phase inverter current Iinv varies between each segment S1 to S7.

At step S301, the processor 200 commands the sampling, at least one time within the time period Tsw, of the output currents in at least two phases of the load 130.

The samples and the switching information are stored in a first buffer at step S302, dimensionned to store these data acquired during some period of time sufficient to enable an accurate calculation of RMS value (calculation will be disclosed in steps S304 to S307).

At step S303, the processor 200 checks if the first buffer is full. If the first buffer is full, the processor 200 moves to step S304. Otherwise, the processor 200 returns to step S300.

Using the switching information of the three-phase inverter 160 and the measured phases currents stored in the first buffer, the processor 200 reconstructs at step S304 the current Iinv for each segment as shown in Fig. 4.

At step S305, the processor 200 performs a digital filtering of the reconstructed current Iinv.

The reconstructed inverter current contains indeed very high frequency components due to the switching of currents. This signal must thus be filtered with a filter presenting the same response for the frequency band as the filter used for the capacitor voltage proccessing.

The filtering is a digital filtering.

For example, the digital filtering can be performed using an infinite impulse response filter IIR with desired frequency response, for instance, similar to that of the analog filter used for voltage filtering. This is a rather straightforward approach which can be applied by evaluating the infinite response filter iteratively in order to determine the filter response and keep the filtered signal value at the same frequency as the capacitor voltage ripple sampling that will be disclosed at step S309, for instance at ten times the frequency Fsw=1/Tsw. Due to the large number of iterations required to calculate an accurate response, the filtering result may take long processing time as the digital integrations require a small Δt, where Δt is a "virtual" small time interval used to divide Tsw, i.e. defines the temporal resolution of the filter response and of the switching positions of inverter current within the switching interval Tsw.

For instance, with Fsw=10 kHz and Δt=lus, the switching interval is divided in 100 small time intervals Δt and the response of the filter throughout the interval requires 100 evaluations of the IIR.

An example is given in reference to Fig. 5.

The Fig. 5 is an example of the digital filtering of the reconstructed current Iinv using an infinite impulse response filter.

The signals Vsah, Vsbh and Vsch are the gate signals provided to the switches Sah, Sbh and Sch. The transitions of signals Vsah, Vsbh and Vsch define different regions or segments within the switching interval Tsw.

The curve Iinv is the current reconstructed from the switching information of the three-phase inverter 160 and the measured currents as already shown in Fig. 4.

The black points are the 10 samples taken at step S306 among the 100 evaluations of the IIR taken at same frequency as the filtered capacitor samples.

Alternatively, in order to accelerate the filtering process, it is possible to use the time-domain solution of the state equations of the filter. The time domain equations can indeed be derived after some work from the state equations of the linear time-invariant (LTI) filter model. The time domain equations of the linear time-invariant filter are function of initial conditions. The input of filter is the reconstructed current Iinv which can be considered as a succession of shifted voltage steps applied to the linear time-invariant filter.

The obtained set of equation enables to calculate much faster and accurately the output response of the filter at points of interest with a limited number of calculation steps.

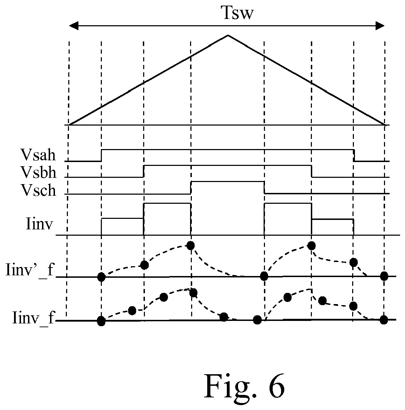

An example is given in reference to Fig. 6.

The Fig. 6 is an example of the digital filtering of the reconstructed current Iinv using the time domain solution of the a linear time-invariant filter.

The signals Vsah, Vsbh and Vsch are the gate signals provided to the switches Sah, Sbh and Sch. The transitions of signals Vsah, Vsbh and Vsch define different regions or segments within the switching interval Tsw.

The curve Iinv is the current reconstructed from the switching information of the three-phase inverter 160 and the measured currents as already shown in Fig. 4.

The filtering process for the reconstructed current within a switching interval is made as follows:
The black points of the signal Inv' f represent the initial and final states of the filtered signal using the time domain solution of the linear time-invariant filter.

The final value of the state variables is calculated at the end of each segment considering the initial conditions of state variables, i.e. their value at the end of the previous segment.

Then, a second iteration is performed to determine the value of filter state variables and output at the points of interest i.e. at multiples of Tsw/n. This is done for each point by determining the segment to which the considered sampling point belongs to, calculate the equations of state variables using the associated initial conditions of the state variables and input of the filter, and then calculating the output sample.

For example, the digital filtering is performed using a first order low pass digital filtering the equation of which is as follows:
Iinv_filt= Iinv-Initval(1-e^{-(t+tinit)/τ}) where Initval is the value of the reconstructed current at the beginning of the segment Si with i=1 to 7, tinit is the time at the beginning of the segment Si, Iinv is the value of calculated inverter current in considered segment; τ is the time constant of the filter. Here, there is only one state variable which also corresponds to the output of filter, thus only one equation to evaluate.

The black points of the signal Inv f are the 10 samples (n=10) taken at step S306, at the same frequency as the sampled filtered DC-bus voltage ripple, that are calculated from the time domain equations and the initial and final states of the linear time-invariant filter.

The processor 200 determines for each segment tinit and Initval, then the processor 200 calculates using the above mentioned formula the filtered current at times tj= j*Tsw/n with j=1 to n. For example, n is equal to 10, the number of samples taken for the same period of time (Tsw) of the filtered DC-bus voltage ripple.

At step S307, the processor 200 calculates the RMS value of the filtered current. The RMS value of the filtered current is calculated from an accumulation performed within a time window that is for example equal to approximately a multiple of the low period disturbance of DC bus, for example around the sixth harmonic of the input frequency if the power converter comprises a three-phase diode rectifier. The accumulation is performed on every sample of filtered current and the final calculation of RMS value (averaging & square root) is performed only once the whole time window is processed, i.e. when the first buffer has been processed entirely.

At step S308, the processor 200 obtains the voltage on the DC-bus capacitor 150 that has been conditioned using a hardware filtering.

The voltage of the DC-bus capacitor is filtered by an analogue filter in order to isolate its high frequency contents of interest and rejecting low frequency disturbance. Filtering is performed by an analogue signal conditioning (DC suppression, pre-attenuation of low frequency disturbances, anti-aliasing). If the amplitude of the low frequency disturbance is still too important, it can be further rejected for example by additional high pass filtering.

At step S309, the filtered DC-bus voltage ripple is sampled every Tsw/n (at a frequency equal to n*Fsw).

The sampling frequency enables to capture the signal with a good accuracy with its frequency contents in the range of interest for the estimation: essentially harmonic 2 of switching frequency for SVPWM modulation. Oversampling factor n must be in theory at least superior or equal to 4, but a higher over-sampling factor such as 10 is preferred because it reduces a lot the constraints on anti-aliasing filtering taking into account a too high over sampling frequency which would add burden to CPU.

The samples are stored in a second buffer at step S310.

At step S311, the processor 200 checks if the second buffer is full. If the second buffer is full, the processor 200 moves to step S312. Otherwise, the processor 200 returns to step S308.

At step S312, the processor 200 calculates the RMS value of the samples of filtered DC-bus voltage ripple stored in the second buffer.

The RMS value of the filtered voltage is calculated from an accumulation within a time window that is for example approximately equal to a multiple of the low period disturbance of DC bus, for example around the sixth harmonic of the input frequency if the power converter comprises a three-phase diode rectifier. The accumulation is performed on every filtered voltage sample and the final calculation of RMS value (averaging & square root) is performed only once the second buffer is full. Typically the second buffer size allows to store samples of filtered DC-bus voltage ripple during the same duration as the filling of first buffer used in step S304.

As a variant, if a current sensor is available to measure the inverter current Iinv, the estimation of HF capacitor current can be obtained with a processing identical to capacitor voltage processing. In that case the steps S300 to S306 are replaced by an acquisition loop similar to the sequence of steps S308 to S311, but with conditioning of measured inverter current Iinv instead of capacitor voltage and the step S307 remains the same.

At step S313, the processor 200 estimates the equivalent serie resistor value of the DC-bus capacitor 150 by dividing the RMS value of the filtered voltage by the RMS value of the filtered current.

At next step S314, the processor 200 checks if the DC-bus capacitor has reached the end of life. The end of life criterion is the estimation of the ESR of the DC-bus capacitor 150 to reach its ageing limit. Ageing limit is reached when the estimation of ESR is upper than an end of life ESR value at the measured or estimated capacitor temperature T. If the ageing limit is reached, the processor 200 moves to step S315 where it activates the alarm to indicate that a maintenance if needed.

The end of life ESR is determined according to an initial self-calibration procedure which is performed following initial power up, or after a maintenance operation.

During a calibration period, for example selectable from a few hours to a few weeks, for each different stabilized operating temperature T, the processor 200 records an expected end of life ESR value calculated relatively to the value of ESR measured at that time, ESRini. For instance ESRlimit = 2*ESRini.

At the end of the self-calibration period, a table of different ends of life ESR values is available stored in non-volatile memory which covers the range of temperatures encountered during calibration, and this will allow future ageing tests. This procedure is performed during normal operation of the power converter and does not create disturbances.

If the end of life criterion is true, the processor 200 commands the transfer at step S315 of an alarm signal that indicates that the DC-bus capacitor 150 has reached its end of life and that a maintenance procedure is required.

Naturally, many modifications can be made to the embodiments of the invention described above without departing from the scope of the present invention.

## Claims

1. Method for on-line monitoring a DC-bus capacitor comprised in a power converter, the power converter controlling the power provided to a load through an output stage at each switching cycle using a pulse width modulation, **characterized in that** the method comprises the steps of:
- measuring the voltage on the DC-bus capacitor, filtering, using an analogue filter, the measured voltage of the DC-bus capacitor in order to obtain filtered DC-bus voltage ripple with frequency contents within a frequency band comprising only high frequency components generated by the pulse width modulation,
- sampling the filtered DC-bus voltage ripple at a sampling rate that is a multiple of the frequency of the pulse width modulation,
- obtaining switching information of the pulse width modulation,
- sampling, at least one time within the time period of the pulse width modulation, the output currents provided to the output stage,
- reconstructing, for each segment of the pulse width modulation, the current provided to the output stage,
- executing a digital filtering of the reconstructed current in order to obtain samples of filtered reconstructed current at the same frequency as the samples of the filtered DC-bus voltage ripple,
- calculating a root mean square value of the filtered DC-bus voltage ripple using the samples of the filtered DC-bus voltage ripple,
- calculating a root mean square value of the filtered reconstructed current using the samples of the filtered reconstructed current,
- determining the equivalent series resistance of the DC-bus capacitor from the calculated root mean square values,
- measuring or estimating the capacitor temperature,
- comparing the equivalent series resistance value to a threshold which depends on the capacitor temperature and determining if the DC-bus capacitor reaches its end of life according to the comparison result.

2. The method according to claim 1, **characterized in that** the digital filtering of the reconstructed current is performed using an infinite impulse response filter.

3. The method according to claim 1, **characterized in that** the digital filtering of the reconstructed current is performed using time domain solutions of a linear time-invariant filter.

4. The method according to any of the claims 1 to 3, **characterized in that** the filtered reconstructed current is sampled at a rate at least equal to four times the frequency of the pulse width modulation.

5. The method according to any of the claims 1 to 4, **characterized in that** the filtered DC-bus voltage ripple is sampled at a rate at least equal to four times the frequency of the pulse width modulation.

6. The method according to any of the claims 1 to 5, **characterized in that** the RMS values are calculated from an accumulation performed within a predetermined time window.

7. The method acccording to any of the claims 1 to 6, **characterized in that** the power converter is a three-phase inverter having a diode rectifier front end.

8. The method acccording to any of the claims 1 to 7, **characterized in that** the pulse width modulation is a space vector modulation.

9. Device for on-line monitoring a DC-bus capacitor comprised in a power converter, the power converter controlling the power provided to a load through an output stage at each switching cycle using a pulse width modulation, **characterized in that** the device comprises:
- means for measuring the voltage on the DC-bus capacitor, filtering, using an analogue filter, the measured voltage of the DC-bus capacitor in order to obtain filtered DC-link voltage ripple with frequency contents within a frequency band comprising only high frequency components generated by the pulse width modulation,
- means for sampling the filtered DC-link voltage ripple at a sampling rate that is a multiple of the frequency of the pulse width modulation,
- means for obtaining switching information of the pulse width modulation,
- means for sampling, at least one time within the time period of the pulse width modulation, the output currents provided to the output stage,
- means for reconstructing, for each segment of the pulse width modulation, the current provided to the output stage,
- means for executing a digital filtering of the reconstructed current in order to obtain samples of filtered reconstructed current at the same frequency as the samples of the filtered DC-link voltage ripple,
- means for calculating a root mean square value of the filtered DC-link voltage ripple using the samples of the filtered DC-link voltage ripple,
- means for calculating a root mean square value of the filtered reconstructed current using the samples of the of filtered reconstructed current,
- means for determining the equivalent series resistance of the DC-bus capacitor from the calculated root mean square values,
- means for measuring or estimating the capacitor temperature,
- means for comparing the equivalent series resistance value to a threshold which depends on the capacitor temperature and determining if the DC-bus capacitor reaches its end of life according to the comparison result.
